# EUROPEAN PATENT SPECIFICATION

(11) **EP 1 097 618 B1**
(45) Date of publication and mention of the grant of the patent: **26.03.2003**
(21) Application number: 99933653.0
(22) Date of filing: 01.07.1999
(51) Int. Cl.: H05K 3/38

(54) **POST-TREATMENT FOR COPPER ON PRINTED CIRCUIT BOARDS**
NACHBEHANDLUNG VON KUPFER AUF GEDRUCKTEN SCHALTUNGSPLATTEN
POST-TRAITEMENT DU CUIVRE SUR DES CARTES DE CIRCUIT IMPRIME

(30) Priority: 01.07.1998 US 91339 P
(43) Date of publication of application: 09.05.2001
(73) Proprietor: FRY'S METALS, INC. d/b/a ALPHA METALS, INC., JERSEY CITY, NJ 07304 (US)
(72) Inventor: MCGRATH, Peter, T., Mission Viejo, CA 92692 (US); OWEI, Abayomi, Rancho Cucamonga, CA 91730 (US); SARDER, Saeed, Lake Mary, FL 32746 (US); YAKOBSON, Eric, San Juan Capistrano, CA 92675 (US)
(74) Representative: Allard, Susan Joyce
(86) International application number: US9914983
(87) International publication number: WO00002426

(56) References cited:
- EP-A- 0 189 913
- WO-A-96/19097
- US-A- 5 261 154

## Description

### Field of the Invention

The present invention relates to a treatment solution and method for copper surfaces on printed circuit boards. More particularly, the present invention relates to a solution and method for improving copper-to-dielectric bond integrity by increasing the chemical resistance of organometallic conversion coatings that are formed on the surface of copper pads and traces on printed circuit boards.

### Background of the Invention

Multilayer circuit boards (MLBs) typically consist of alternating layers of copper and dielectric material, which are laminated together. There are a variety of MLBs on the market today. Depending on the materials they are made of, they can be rigid (if formed from rigid materials such as glass-reinforced epoxy-resin, BT, CE, PTFE, etc.), flexible (if formed from flexible materials such as polyester or polyimide) or they can be a combination, (i.e., so-called "rigid-flex"). If the alternating layers of copper and dielectric are applied one onto another in a sequential process rather than laminated simultaneously into a single package, they are classified as Sequential Build-Up (SBU) Boards. The integrity of MLB depends upon a reliable bond being formed between the copper and dielectric. In conventional MLB manufacturing processes, copper layers are treated using a hydroxide/chlorite based treatment solution. This so-called "Black Oxide Process" provides an enhanced copper-to-dielectric bond. Examples and details of the Black Oxide Process are set forth in, for example, U.S. Patents 4,358,479; 4.409,037; 4,512,818; 4,844,981 and 4,969,958. However, the Black Oxide Process suffers from various limitations including the following:
1. The process can be carried out only in an aggressive strongly alkaline solution at about 160-170 °F.
2. The processing time is long, thereby creating bottlenecks in the manufacturing sequence.
3. The Black Oxide coating readily dissolves in acids, which makes it susceptible to acid attack in subsequent processing steps. This frequently results in an undesirable phenomenon commonly referred to as "pink ring" and sometimes can even result in "wedge voids" and ultimately delamination between the copper and adjacent dielectric layer.
4. The initially high bond strength between the Black Oxide coated copper and the dielectric material usually deteriorates rapidly as the MLB passes through subsequent thermal excursions during the fabrication and assembly processes.

A reliable copper-to-dielectric bond is especially important for flex and SBU circuit boards. Polyimides, which are used for flexible boards, and photo-imageable dielectrics used for SBU circuit boards, are known to exhibit lower copper-to-dielectric bond strength than conventional epoxy-glass based rigid circuit boards.

The Black Oxide coating comprises a mixture of cupric and cuprous oxides. This coating exhibits poor chemical resistance on the basis that it is predominantly formed of cupric oxide. Unlike cupric oxide (black) which is easily attacked by acids, cuprous oxide (red to brown) is relatively chemically inert.

In an attempt to eliminate "pink ring" and to prevent deterioration of the bond strength, two types of post-treatments for the Black Oxide Process have been developed. The first type is based on a reduction process as disclosed in, for example, U.S. Patents 4,642,161; 4,902,551; 5,006,200; 5,076,864; 5,147,492; 5,382,333; 5,492,595; 5,556,532 and 5,721,014. The second Black Oxide post-treatment type is based on partial dissolution of the oxide coating as described in, for example, U.S. Patents 4,717,439; 4,775,444; 5,106,454; 5,261,154; 5,289,630 and 5,501,350. Both of these techniques achieve similar results, although they do so through different chemical mechanisms. The first mechanism is a reduction process, which partially converts the cupric oxide into a mixture of cuprous oxide and metallic copper. The second mechanism is a dissolution process, which selectively dissolves cupric oxide, thereby leaving cuprous oxide on the surface. Both processes convert Black Oxide (predominantly cupric) into a surface rich in cuprous oxide. Unfortunately, however, although Black Oxide reduction and dissolution post-treatments do eliminate "pink ring" and improve the acid resistance of the coating to some extent, they do not solve all of the above mentioned problems associated with the Black Oxide performance.

Furthermore, reduced Black Oxide has been found to suffer from a rapid re-oxidation of the surface during baking steps, which are used in MLB manufacturing processes in order to remove absorbed moisture from the dielectric prior to the lamination steps. The re-oxidation of the surface manifests itself by a noticeable darkening of the coating after the baking step. The darker color of the coating indicates the reappearance of cupric oxide, which once again makes the coating more susceptible to chemical attack in subsequent processing steps.

Partially dissolved Black Oxide is susceptible to the formation of a powdery, poorly adherent layer of cuprous oxide which forms on the surface due to undercutting action of the chemical bath used for the dissolution. This powdery portion of the coating prevents the formation of a strong copper-to-dielectric bond. In addition, it makes it impossible to use this process in a horizontal conveyorized mode due to the formation of roller marks, which can occur in the powdery surface.

Recently a new alternative to the Black Oxide Process described above has been introduced. Instead of forming cupric oxide, it produces an organometallic conversion coating (OMCC) on the copper surface. In general, the purpose of organometallic conversion coatings is to form a barrier layer on the underlying metal surface, thereby protecting it from oxidation and corrosion, and/or increasing its bond to the dielectric material. OMCCs are the product of a chemical reaction between metal ions (in single or multiple valency states) and organic compounds. As such, they are readily distinguished from inorganic Black Oxide. The OMCC comprises a film of metal ions tied into a complex or otherwise bonded with one or more organic materials. Such processes for forming an OMCC are disclosed in U.S. Patents 5,800,859 and 5,869,130.

The organometallic conversion coating that forms during this process is much more acid resistant than Black Oxide coatings. It is not, however, completely impervious to chemical attack since it still contains a portion of a cupric-based organometallic compound in its composition.

The mechanism of the "wedge void" formation discussed below will illustrate the significance of the inventive post-treatment step.

After lamination the MLB panels are drilled. During the drilling operation, vibration of the drill bit can create microfractures in the copper/dielectric interface. Solvent conditioners then can get absorbed into the microgaps between the copper and the dielectric. Subsequent treatment with permanganate solution will oxidize, i.e. remove, this already swelled resin creating a "wedge". Microetch solution will attack the copper and widen the gap. Pre-dip and activator solutions typically are fairly concentrated hydrochloric acid based solutions, which will further remove the copper treatment layer. If electroless copper fails to completely seal the "wedge", the chemical attack will continue when the article is immersed in acid cleaner, microetch solution, acid dip and acid copper. When the "wedge" is relatively small, acid copper will completely fill the gap resulting in typical "pink ring" appearance. If the gap is large enough, it may bridge only partially or may not bridge at all leading to a "wedge void" defect. In the most severe cases, the result is delamination.

The above notwithstanding, a need still exists for an improved method of enhancing the copper to dielectric bond in MLBs, while at the same time providing enhanced chemical resistance to the resulting article.

### Summary of the Invention

The present invention relates to a treatment solution and process that overcomes the problems associated with known methods for enhancing the copper to dielectric bond during MLB manufacture. More particularly, the present invention relates to a method for enhancing the bond integrity by increasing chemical resistance of the adhesion promoting copper coating by converting cupric-based organometallic compounds on the copper surface into cuprous-based organometallic conversion coatings. This is achieved by reduction and/or by partial dissolution of the organometallic coating, and optionally applying a copper oxidation inhibitor at the same time.

### Detailed Description of the Invention

The basis of the present invention is to significantly improve chemical resistance of an organometallic conversion coating (OMCC) making it resistant to chemical attack during the desmear, electroless copper and acid copper electroplating processes, thereby eliminating "pink ring", "wedge voids" and a propensity towards delamination due to chemical attack and enhancing the bond integrity. Improved chemical resistance can be accomplished by converting most of the cupric-based organometallic compound on the surface into a cuprous-based organometallic conversion coating. This conversion can be achieved by reduction and/or by dissolution. Post-treated OMCC can be easily differentiated from either reduced or partially dissolved Black Oxide. The latter is claimed to consist primarily of metallic copper. Reduced OMCC remains an organometallic complex in which most of the divalent copper is reduced to monovalent. Similarly, partially dissolved Black Oxide is still a mixture of cuprous and cupric oxides, while partially dissolved OMCC is an organometallic complex based primarily on monovalent copper. Optionally, the composition can contain a copper oxidation inhibitor or a combination of several inhibitors in order to prevent re-oxidation of the OMCC in subsequent processing steps. The resulting cuprous-based OMCC is substantially more resilient and resistant to subsequent MLB processing steps, than either post-treated Black Oxide or untreated OMCC.

A great variety of materials can be used for reduction or dissolution of OMCC. One of the most effective reducers is DMAB (dimethylaminoborane), although other aminoboranes (e.g. diethylaminoborane, morpholine borane, etc.) can be used as well. Other reducers that can be utilized for this application are: ammonium, alkali and/or alkaline earth metal borohydrides, hypophosphites, sulfites, bisulfites, hydrosulfites, metabisulfites, dithionates, tetrathionates, thiosulfates, thioureas, hydrazines, hydroxylamines, aldehydes (including formaldehyde and glyoxal), glyoxylic acid and reducing sugars. Electric current can be used for the reduction as well.

If dissolution agents are to be used, any of the known cupric ion chelators (complexors), organic or inorganic acids and/or their salts, (or a combination of them), can be utilized for this application. These include EDTA, HEEDTA, NTA, DTPA, DCTA, Quadrol, organic phosphonates (Dequests), organic acids (citric, tartaric, gluconic, glutamic, sulfamic, glycolic, glycine, malic, maleic, salicylic, ascorbic, formic, etc.), inorganic acids (hydrochloric, hydrofluoric, hydrobromic, nitric, chromic acids, etc.), and/or their ammonium, alkali, alkaline earth metal and/or amine salts, amines (MEA, DEA, TEA, TMAH, EDA, DETA, TETA, TEPA, etc.), ammonium hydroxide, pyrophosphates, etc. Quadrol, EDTA and phosphonates are preferred. Additionally, it may be advantageous to use the dissolution agents with one or more reducing agents.

As noted above, copper oxidation inhibitors may optionally be used as well. Thus, for example, one or more of the following copper oxidation inhibitors can be incorporated into the composition: unsubstituted and/or alkyl-, aryl-, alkylaryl-substituted azole derivatives, (including halogen substituted derivatives thereof), e.g. benzotriazol (BTA), tolyltriazol (TTA), 5-methylbenzimidazole, 2-bromobenzyl benzimidazole, 2-chlorobenzyl benzymidazole, 2-bromophenyl benzimidazole, 2-chlorophenyl benzimidazole, 2-bromoethylphenyl benzimidazole, 2-chloroethylphenyl benzimidazole and 2-undecyl-4-methylimidazole. benzotriazol and tolyltriazol are preferred. Cationic, amphoteric, anionic and/or non-ionic surfactants can also be utilized to enhance the effectiveness of the post-treatment solution.

A combination of a reducer (or any number of reducers) with a dissolution agent (or any number of dissolution agents) can be used as well. The pH, temperature, concentration and processing time should be adjusted appropriately to insure effective reduction and/or dissolution of the cupric ion. Optionally, this solution may contain an oxidation inhibitor or a combination of several inhibitors.

It should be understood, as well, that the materials described above, while useful as a post-treatment following formation of the organometallic conversion coating, need not be limited to post-treatment applications. Rather, treatment may be accomplished by incorporating such materials directly into the solution used to form the original organometallic conversion coating.

### Examples

### Example 1

A piece of 1 oz. DSTFoil (available from Polyclad Laminates) and an epoxy-glass laminate panel clad with the same DSTFoil on both sides (Polyclad Laminates) were processed through the sequence of the following steps:

| | | |
|---|---|---|
| 1. | PC 7036 Microetch (available from Alpha PC Fab) | 90°F, 1 min. |
| 2. | Rinse | ambient, 1 min. |
| 3. | PC 7086 Alkaline Cleaner (Alpha PC Fab) | 130°F, 1 min. |
| 4. | DI Rinse | ambient, 1 min. |
| 5. | Pre-Dip (5% PC-7023) | 105°F, 30 sec. |
| 6. | PC 7023 Adhesion Promoter (Alpha PC Fab) | 105°F, 1 min. |
| 7. | DI Rinse | ambient, 1 min. |
| 8. | Hot Air Dry | 160°F, 1min. |

Subsequently, the foil was laid-up with two layers of Polyclad 1080 B-stage pre-preg (available from Polyclad Laminates) and two layers of Polyclad 7628 pre-preg on one side, treatment layer facing the 1080 pre-preg. The DSTFoil clad copper/epoxy-glass laminate was laid-up with two layers of Polyclad 2313 on each side. Both lay-ups were then pressed at 370°F temperature and 350 psi pressure for 60 minutes.

The laminated foil panel was masked with 1/8 inch wide tape and the exposed copper was etched off in 500 g/L ferric chloride solution at 130°F. The panel was rinsed, dried and the masking tape was removed. The adhesion of the copper foil to the cured epoxy resin was then tested by peeling back the 1/8 inch wide copper strips using CECO TA 620-30 Peel Tester. The adhesion was found to be 6.76 Lb/in.

The laminated copper clad panel was cut into 2 inch wide strips, which were subsequently immersed into PC 7457 HASL flux (available from Alpha PC Fab) and then into the molten solder at 500°F. Every minute a strip was taken out of the solder and checked for signs of delamination. The time-to-delamination was found to be 9 minutes.

### Example 2

Example 1 was repeated with the exception that the DSTFoil and the copper clad laminate after the treatment in PC 7023 Adhesion Promoter were immersed in the solution made up from 6 g/L DMAB and 7.5 g/L KOH at 105°F for 2 minutes. The adhesion was found to be 7.36 Lb/in and the time-to-delamination was 9 minutes and 30 seconds.

### Example 3

A piece of standard 1 oz. foil was taped to a circuit board panel and processed using the same steps as in Example I in Coates-ASI horizontal conveyorized wet processing spray machine. The tape was removed and the foil was laminated and tested for adhesion as in Example 1. The adhesion was found to be 4.6 Lb/in.

### Example 4

Example 3 was repeated with the exception that after the processing in the horizontal equipment the foil was immersed in 5% (vol.) HCL for 1 min. at ambient temperature. The adhesion was 5.1 Lb/in.

### Example 5

Example 4 was repeated with the exception that 38 g/L Na₂EDTA solution was used as the post-treatment at 130°F, pH 4.1 for 6 min. The adhesion was 6.2 Lb/in.

### Example 6

Example 4 was repeated with the exception that 76 g/L Na₂EDTA solution was used as the post-treatment at 130°F, pH 4.1 for 1 min. The adhesion was 6.6 Lb/in.

### Example 7

Example 4 was repeated with the exception that 10% (vol.) Versene 100 (EDTA solution available from Dow Chemical) solution was used as the post-treatment at 130°F, pH 10 for 1 min. The adhesion was 6.8 Lb/in.

### Example 8

Example 4 was repeated with the exception that 10% (vol.) Versene 100 solution was used as the post-treatment at 130°F, pH 13 for 1 min. The adhesion was 6.9 Lb/in.

### Example 9

Example 4 was repeated with the exception that 10% (vol.) Quadrol (ethoxylated/propoxylated ethylene diamine derivative available from BASF) solution was used as the post-treatment at 130°F, pH 10 for 1 min. The adhesion was 6.9 Lb/in.

### Example 10

Example 4 was repeated with the exception that 10% (vol.) Quadrol solution was used as the post-treatment at 130°F, pH 13 for 1 min. The adhesion was 6.9 Lb/in.

### Equivalents

From the foregoing detailed description of the specific embodiments of the invention, it should be apparent that a unique process for converting a cupric-based organometallic conversion coating into a cuprous-based organometallic conversion coating has been described. Although particular embodiments have been disclosed herein in detail, this has been done by way of example for purposes of illustration only, and is not intended to be limiting with respect to the scope of the appended claims which follow.

## Claims

1. A method for treating copper surfaces on printed circuit boards comprising the steps of:
a) providing a printed circuit board having a copper surface thereon;
b) forming a cupric-based organometallic conversion coating on at least a portion of the copper surface;
c) contacting the cupric-based organometallic conversion coating with a treatment solution, the treatment solution causing a reduction reaction, a dissolution reaction or both at the cupric-based organometallic conversion coating, thereby substantially converting the cupric-based organometallic conversion coating into a cuprous-based organometallic conversion coating.

2. The method of claim 1, which further includes the step of applying a copper oxidation inhibitor to the cupric-based organometallic conversion coating.

3. The method of claim 2, wherein the copper oxidation inhibitor is applied simultaneously with the treatment solution.

4. The method of claim 3, wherein the copper oxidation inhibitor is incorporated into the treatment solution.

5. The method of claim 1, wherein the treatment solution causes a reduction reaction, such reduction reaction resulting from contacting the cupric-based organometallic conversion coating with an aminoborane.

6. The method of claim 5, wherein the aminoborane is selected from the group consisting of dimethylaminoborane, diethylaminoborane, and morpholine borane.

7. The method of claim 1, wherein the treatment solution causes a reduction reaction, such reduction reaction resulting from contacting the cupric-based organometallic conversion coating with a reducing agent selected from the group consisting of ammonium, alkali and/or alkaline earth metal borohydrides, hypophosphites, sulfites. bisulfites, hydrosulfites, metabisulfites, dithionates, tetrathionates, thiosulfates, thioureas, hydrazines, hydroxylamines, aldehydes, glyoxylic acid and reducing sugars.

8. The method of claim 1, wherein the treatment solution causes a dissolution reaction, such dissolution reaction resulting from contacting the cupric-based organometallic conversion coating with a cupric ion chelator.

9. The method of claim 1, wherein the treatment solution causes a dissolution reaction, such dissolution reaction resulting from contacting the cupric-based organometallic conversion coating with organic or inorganic acids and/or the salts of organic or inorganic acids.

10. The method of claim 1, wherein the treatment solution is incorporated into a solution used to form a cupric-based organometallic conversion coating.

11. The method of claim 1, wherein the treatment solution causes a dissolution reaction, such dissolution reaction resulting from contacting the cupric-based organometallic conversion coating with a material selected from the group consisting of EDTA, HEEDTA, NTA, DTPA, DCTA, Quadrol, organic phosphonates.

12. The method of claim 9, wherein the organic acids are selected from the group consisting of citric acid, tartaric acid, gluconic acid, glutamic acid, sulfamic acid, glycolic acid, glycine acid, malic acid, maleic acid, salicylic acid, ascorbic acid, formic acid, and combinations thereof.

13. The method of claim 9, wherein the inorganic acids are selected from the group consisting of hydrochloric acid, hydrofluoric acid, hydrobromic acid, nitric acid, chromic acid and mixtures thereof.

14. The method of claim I, wherein the treatment solution causes a dissolution reaction, such dissolution reaction resulting from contacting the cupric-based organometallic conversion coating with an amine.

15. The method of claim 14, wherein the amine is selected from the group consisting of MEA, DEA, TEA, TMAH, EDA, DETA, TETA, and TEPA

16. The method of claim 1, wherein the treatment solution causes a dissolution reaction, such dissolution reaction resulting from contacting the cupric-based organometallic conversion coating with ammonium hydroxide or a pyrophosphate.

17. The method of claim 2, wherein the copper oxidation inhibitor is selected from the group consisting of unsubstituted azole derivatives, alkyl-substituted azole derivatives, aryl-substituted azole derivatives, alkylaryl-substituted azole derivatives, and combinations and halogen substituted derivatives thereof.

18. The method of claim 17, wherein the copper oxidation inhibitor is selected from the group consisting of BTA, TTA, 5-methylbenzimidazole, 2-bromobenzyl benzimidazole, 2-chlorobenzyl benzimidazole, 2-bromophenyl benzimidazole, 2-chlorophenyl benzimidazole, 2-bromoethylphenyl benzimidazole, 2-chloroethylphenyl benzimidazole and 2-undecyl-4-methylimidazole and combinations thereof.

19. The method of claim 2 wherein the treatment solution further comprises a surfactant.

20. The method of claim 19 wherein the surfactant is selected from the group consisting of ionic surfactants.

21. The method of claim 19 wherein the surfactant is selected from the group consisting of non-ionic surfactants.

22. A method for treating copper surfaces on printed circuit boards comprising the steps of:
a) providing a printed circuit board having a copper surface thereon;
b) forming a cupric-based organometallic conversion coating on at least a portion of the copper surface; c) exposing the cupric-based organometallic conversion coating to an electric current under conditions sufficient to substantially convert the cupric-based organometallic conversion coating into a cuprous-based organometallic conversion coating.

23. The method of claim 22, which further includes the step of applying a copper oxidation inhibitor to the cupric-based organometallic conversion coating.

24. The method of claim 23, wherein the copper oxidation inhibitor is applied during the exposure to the electric current.

25. A method for treating copper surfaces on printed circuit boards comprising the steps of:
a) providing a printed circuit board having a copper surface thereon;
b) forming a cupric-based organometallic conversion coating on at least a portion of the copper surface;
c) contacting the cupric-based organometallic conversion coating with a treatment solution, the treatment solution comprising an inhibitor of copper oxidation and a dimethylaminoborane, and being applied under conditions sufficient to substantially convert the cupric-based organometallic conversion coating into a cuprous-based organometallic conversion coating.

## Patentansprüche

1. Verfahren zur Behandlung von Kupferoberflächen auf gedruckten Schaltungsplatten, umfassend die Schritte:
a) Bereitstellen einer gedruckten Schattungsplatte mit einer Kupferoberfläche darauf;
b) Bilden einer Kupfer(II)-basierenden organometallischen Umwandlungsbeschichtung auf mindestens einem Teil der Kupferoberfläche;
c) Kontaktieren der Kupfer(II)-basierenden organometallischen Umwandlungsbeschichtung mit einer Behandlungslösung, wobei die Behandlungslösung eine Reduktionsreaktion, eine Lösungsreaktion oder beides an der Kupfer(I)-basierenden organometallischen Umwandlungsbeschichtung bewirkt, wobei die Kupfer(II)-basierende organometallische Umwandlungsschichtung in eine Kupfer(I)-basierende organometallische Umwandlungsbeschichtung überführt wird.

2. Verfahren nach Anspruch 1, weiterhin einschließend den Schritt des Aufbringens eines Kupferoxidationsinhibitors auf die Kupfer(II)-basierende organometallische Umwandlungsbeschichtung.

3. Verfahren nach Anspruch 2, worin der Kupferoxidationsinhibitor simultan mit der Behandlungslösung aufgebracht wird.

4. Verfahren nach Anspruch 3, worin der Kupferoxidationsinhibitor in die Behandlungslösung inkorporiert ist.

5. Verfahren nach Anspruch 1, worin die Behandlungslösung eine Reduktionsreaktion bewirkt, wobei die Reduktionsreaktion aus dem Kontaktieren der Kupfer(II)-basierenden organometallischen Umwandlungsbeschichtung mit einem Aminoboran resultiert.

6. Verfahren nach Anspruch 5, worin das Aminoboran ausgewählt ist aus der Gruppe, bestehend aus Dimethylaminoboran, Diethylaminoboran und Morpholinboran.

7. Verfahren nach Anspruch 1, worin die Behandlungslösung eine Reduktionsreaktion bewirkt, wobei die Reduktionsreaktion aus dem Inkontaktbringen der Kupfer(II)-basierenden organometallischen Umwandlungsbeschichtung mit einem Reduktionsmittel resultiert, wobei das Reduktionsmittel ausgewählt ist aus der Gruppe, bestehend aus Ammonium-, Alkali- und/oder Erdalkalimetallborhydriden, -hypophosphiten, -sulfiten, -biisulfiten, -hydrosulfiten, -metabisulfiten, -dithionaten, -tetrathionaten, -thiosulfaten, Thioharnstoffen, Hydrazinen, Hydroxylaminen, Aldehyden, Glyoxylsäure und reduzierenden Zuckern.

8. Verfahren nach Anspruch 1, worin die Behandlungslösung eine Lösungsreaktion bewirkt, wobei eine solche Lösungsreaktion aus Kontaktieren der Kupfer(II)-basierenden organometallischen Umwandlungsbeschichtung mit einem Kupfer(II)-Ionen-Chelator resultiert.

9. Verfahren nach Anspruch 1, worin die Behandlungslösung eine Lösungsreaktion verursacht, wobei eine solche Lösungsreaktion aus dem Kontaktieren der Kupfer(II)-basierenden organometallischen Umwandlungsbeschichtung mit organischen oder anorganischen Säuren und/oder Salzen von organischen oder anorganischen Säuren resultiert.

10. Verfahren nach Anspruch 1, worin die Behandlungslösung in eine Lösung inkorporiert ist, welche verwendet wird, um eine Kupfer(II)-basierende organometallische Umwandlungsbeschichtung zu bilden.

11. Verfahren nach Anspruch 1, worin die Behandlungslösung eine Lösungsreaktion verursacht, wobei eine solche Lösungsreaktion aus dem Inkontaktbringen der Kupfer(II)-basierenden organometallischen Umwandlungsbeschichtung mit einem Material resultiert, welches ausgewählt ist aus der Gruppe, bestehend aus EDTA, HEEDTA, NTA, DTPA, DCTA, Quadrol und organischen Phosphonaten.

12. Verfahren nach Anspruch 9, worin die organischen Säuren ausgewählt sind aus der Gruppe, bestehend aus Zitronensäure, Weinsäure, Gluconsäure, Glutaminsäure, Sulfaminsäure, Glykolsäure, Glycinsäure, Äpfelsäure, Maleinsäure, Salicylsäure, Ascorbinsäure, Ameisensäure und Kombinationen davon.

13. Verfahren nach Anspruch 9, worin die anorganischen Säuren ausgewählt sind aus der Gruppe, bestehend aus Chlorwasserstoffsäure, Fluorwasserstoffsäure, Bromwasserstoffsäure, Salpetersäure, Chromsäure und Mischungen davon.

14. Verfahren nach Anspruch 1, worin die Behandlungslösung eine Lösungsreaktion verursacht, wobei eine solche Lösungsreaktion aus Inkontaktbringen der Kupfer(II)-basierenden organometallischen Umwandlungsschicht mit einem Amin resultiert.

15. Verfahren nach Anspruch 14, worin das Amin ausgewählt ist aus der Gruppe, bestehend aus MEA, DEA, TEA, TMAH, EDA, DETA, TETA und TEPA.

16. Verfahren nach Anspruch 1, worin die Behandlungslösung eine Lösungsreaktion verursacht, wobei eine solche Lösungsreaktion aus Inkontaktbringen der Kupfer(II)-basierenden organometallischen Umwandlungsbeschichtung mit Ammoniumhydroxid oder einem Pyrophosphat resultiert.

17. Verfahren nach Anspruch 2, worin der Kupferoxidationsinhibitor ausgewählt ist aus der Gruppe, bestehend aus unsubstituierten Azolderivaten, Alkyl-substituierten Azolderivaten, Aryl-substituierten Azolderivaten, Alkylaryl-substituierten Azolderivaten und Kombinationen und Halogen-substituierten Derivaten davon.

18. Verfahren nach Anspruch 17, worin der Kupferoxidationsinhibitor ausgewählt ist aus der Gruppe, bestehend aus BTA, TTA, 5-Methylbenzimidazol, 2-Brombenzylbenzimidazol, 2-Chlorbenzylbenzimidazol, 2-Bromphenylbenzimidazol, 2-Chlorphenylbenzimidazol, 2-Bromethylphenylbenzimidazol, 2-Chlorethylphenylbenzimidazol und 2-Undecyl-4-methylimidazol und Kombinationen davon.

19. Verfahren nach Anspruch 2, worin die Behandlungslösung außerdem ein oberflächenaktives Mittel umfasst.

20. Verfahren nach Anspruch 19, worin das oberflächenaktive Mittel ausgewählt ist aus der Gruppe, bestehend aus ionischen oberflächenaktiven Mitteln.

21. Verfahren nach Anspruch 19, worin das oberflächenaktive Mittel ausgewählt ist aus der Gruppe, bestehend aus nicht-ionischen oberflächenaktiven Mitteln.

22. Verfahren zur Behandlung von Kupferoberflächen auf gedruckten Schaltungsplatten, umfassend die Schritte:
a) Bereitstellen einer gedruckten Schaltungsplatte mit einer Kupferoberfläche darauf,
b) Bilden einer Kupfer(II)-basierenden organometallischen Umwandlungsbeschichtung auf mindestens einem Teil der Kupferoberfläche,
c) das einem elektrischem Strom Aussetzen der Kupfer(II)-basierenden organometallischen Umwandlungsbeschichtung unter Bedingungen, welche ausreichend sind, um die Kupfer(II)-basierende organometallische Umwandlungsbeschichtung im Wesentlichen in eine Kupfer(I)-basierende organometallische Umwandlungsbeschichtung umzuwandeln.

23. Verfahren nach Anspruch 22, welches weiterhin den Schritt des Aufbringens eines Kupferoxidationsinhibitors auf die Kupfer(II)-basierende organometallische Umwandlungsbeschichtung einschließt.

24. Verfahren nach Anspruch 23, worin der Kupferoxidationsinhibitor während des einem elektrischen Strom Aussetzens angewandt wird.

25. Verfahren zur Behandlung von Kupferoberflächen auf gedruckten Schaltungsplatten, umfassend die Schritte:
a) Bereitstellen einer gedruckten Schaltungsplatte mit einer Kupferoberfläche darauf;
b) Bilden einer Kupfer(II)-basierenden organometallischen Umwandlungsbeschichtung auf mindestens einem Teil der Kupferoberfläche;
c) Inkontaktbringen der Kupfer(II)-basierenden organometallischen Umwandlungsbeschichtung mit einer Behandlungslösung, wobei die Behandlungslösung einen Kupferoxidationsinhibitor und ein Dimethylaminoboran umfasst, und unter Bedingungen aufgebracht wird, welche ausreichend sind, um die Kupfer-(II)-basierende organometallische Umwandlungsbeschichtung im Wesentlichen in eine Kupfer(I)-basierende organometallische Umwandlungsbeschichtung zu überführen.

## Revendications

1. Procédé pour le traitement de surfaces de cuivre sur des cartes à circuits imprimés, comprenant les étapes consistant :
a) à prendre une carte à circuits imprimés, portant une surface de cuivre ;
b) à former un revêtement de conversion organométallique à base cuivrique sur au moins une partie de la surface de cuivre ;
c) à mettre en contact le revêtement de conversion organométallique à base cuivrique avec une solution de traitement, la solution de traitement provoquant une réaction de réduction ou réaction de dissolution ou bien ces deux réactions au niveau du revêtement de conversion organométallique à base cuivrique, ce qui convertit substantiellement le revêtement de conversion organométallique à base cuivrique en un revêtement de conversion organométallique à base cuivreuse.

2. Procédé suivant la revendication 1, qui comprend en outre l'étape d'application d'un inhibiteur d'oxydation du cuivre au revêtement de conversion organométallique à base cuivrique.

3. Procédé suivant la revendication 2, dans lequel l'inhibiteur d'oxydation du cuivre est appliqué simultanément avec la solution de traitement.

4. Procédé suivant la revendication 3, dans lequel l'inhibiteur d'oxydation du cuivre est incorporé à la solution de traitement.

5. Procédé suivant la revendication 1, dans lequel la solution de traitement provoque une réaction de réduction, cette réaction de réduction résultant de la mise en contact du revêtement de conversion organométallique à base cuivrique avec un aminoborane.

6. Procédé suivant la revendication 5, dans lequel l'aminoborane est choisi dans le groupe consistant en le diméthylaminoborane, le diéthylaminoborane et le morpholinoborane.

7. Procédé suivant la revendication 1, dans lequel la solution de traitement provoque une réaction de réduction, cette réaction de réduction résultant de la mise en contact du revêtement de conversion organométallique à base cuivrique avec un agent réducteur choisi dans le groupe consistant en des borohydrures, hypophosphites, sulfites, bisulfites, hydrosulfites, métabisulfites, dithionates, tétrathionates et thiosulfates d'ammonium, de métaux alcalins et/ou de métaux alcalino-terreux, thio-urées, hydrazines, hydroxylamines, aldéhydes, acide glyoxylique et sucres réducteurs.

8. Procédé suivant la revendication 1, dans lequel la solution de traitement provoque une réaction de dissolution, cette réaction de dissolution résultant de la mise en contact du revêtement de conversion organométallique à base cuivrique avec un agent chélatant les ions cuivriques.

9. Procédé suivant la revendication 1, dans lequel la solution de traitement provoque une réaction de dissolution, cette réaction de dissolution résultant de la mise en contact du revêtement de conversion organométallique à base cuivrique avec des acides organiques ou inorganiques et/ou les sels d'acides organiques ou inorganiques.

10. Procédé suivant la revendication 1, dans lequel la solution de traitement est incorporée à une solution utilisée pour former un revêtement de conversion organométallique à base cuivrique.

11. Procédé suivant la revendication 1, dans lequel la solution de traitement provoque une réaction de dissolution, cette réaction de dissolution résultant de la mise en contact du revêtement de conversion organométallique à base cuivrique avec une matière choisie dans le groupe consistant en EDTA, HEEDTA, NTA, DTPA, DCTA, Quadrol et phosphonates organiques.

12. Procédé suivant la revendication 9, dans lequel les acides organiques sont choisis dans le groupe consistant en l'acide citrique, l'acide tartrique, l'acide gluconique, l'acide glutamique, l'acide sulfamique, l'acide glycolique, l'acide glycinique, l'acide malique, l'acide maléique, l'acide salicylique, l'acide ascorbique, l'acide formique et leurs associations.

13. Procédé suivant la revendication 9, dans lequel les acides inorganiques sont choisis dans le groupe consistant en l'acide chlorhydrique, l'acide fluorhydrique, l'acide bromhydrique, l'acide nitrique, l'acide chromique et leurs mélanges.

14. Procédé suivant la revendication 1, dans lequel la solution de traitement provoque une réaction de dissolution, cette réaction de dissolution résultant de la mise en contact du revêtement de conversion organométallique à base cuivrique avec une aminé.

15. Procédé suivant la revendication 14, dans lequel l'amine est choisie dans le groupe consistant en MEA, DEA, TEA, TMAH, EDA, DETA, TETA et TEPA.

16. Procédé suivant la revendication 1, dans lequel la solution de traitement provoque une réadtion de dissolution, cette réaction de dissolution résultant de la mise en contact du revêtement de conversion organométallique à base cuivrique avec de l'hydroxyde d'ammonium ou un pyrophosphate.

17. Procédé suivant la revendication 2, dans lequel l'inhibiteur d'oxydation du cuivre est choisi dans le groupe consistant en des dérivés d'azole non substitués, des dérivés d'azole à substituants alkyle, des dérivés d'azole à substituants aryle, des dérivés d'azole à substituants alkylaryle et leurs associations ainsi que leurs dérivés à substituants halogéno.

18. Procédé suivant la revendication 17, dans lequel l'inhibiteur d'oxydation du cuivre est choisi dans le groupe consistant en BTA, TTA, 5-méthylbenzimidazole, 2-bromobenzylbenzimidazole, 2-chlorobenzylbenzimidazole, 2-bromophénylbenzimidazole, 2-chlorophénylbenzimidazble, 2-bromoéthylphénylbenzimidazole, 2-chloroéthylphénylbenzi-midazole et 2-undécyl-4-méthylimidazole et leurs associations.

19. Procédé suivant la revendication 2, dans lequel la solution de traitement comprend en outre un agent tensio-actif.

20. Procédé suivant la revendication 19, dans lequel l'agent tensio-actif est choisi dans le groupe consistant en agents tensio-actifs ioniques.

21. Procédé suivant la revendication 19, dans lequel l'agent tensio-actif est choisi dans le groupe consistant en agents tensio-actifs non-ioniques.

22. Procédé pour le traitement de surfaces de cuivre sur des cartes à circuits imprimés, comprenant les étapes consistant :
a) à prendre une carte à circuits imprimés portant une surface de cuivre ;
b) à former un revêtement de conversion organométallique à base cuivrique sur au moins une partie de la surface de cuivre ;
c) à exposer le revêtement de conversion organométallique à base cuivrique à un courant électrique dans des conditions suffisantes pour convertir substantiellement le revêtement de conversion organométallique à base cuivrique en un revêtement de conversion organométallique à base cuivreuse.

23. Procédé suivant la revendication 22, qui comprend en outre l'étape d'application d'un inhibiteur d'oxydation du cuivre au revêtement de conversion organométallique à base cuivrique.

24. Procédé suivant la revendication 23, dans lequel l'inhibiteur d'oxydation du cuivre est appliqué pendant l'exposition au courant électrique.

25. Procédé pour le traitement de surfaces de cuivre sur des cartes à circuits imprimés, comprenant les étapes consistant :
a) à prendre une carte à circuits imprimés portant une surface de cuivre ;
b) à former un revêtement de conversion organométallique à base cuivrique sur au moins une partie de la surface de cuivre ;
c) à mettre en contact le revêtement de conversion organométallique à base cuivrique avec une solution de traitement, la solution de traitement comprenant un inhibiteur d'oxydation du cuivre et un diméthylaminoborane et étant appliquée dans des conditions suffisantes pour convertir substantiellement le revêtement de conversion organométallique à base cuivrique en un revêtement de conversion organométallique à base cuivreuse.
